# EUROPÄISCHE PATENTSCHRIFT

(11) **EP 0 794 614 B1**
(45) Veröffentlichungstag und Bekanntmachung des Hinweises auf die Patenterteilung: **29.10.2003**
(21) Anmeldenummer: 97103411.1
(22) Anmeldetag: 01.03.1997
(51) Int. Cl.: H03G 11/02

(54) **Amplitudenbegrenzer für ein HF-Signal**
Amplitude limiter for HF-Signal
Limiteur d'amplitude pour signaux haute fréquence

(30) Priorität: 05.03.1996 DE 19608441
(43) Veröffentlichungstag der Anmeldung: 10.09.1997
(73) Patentinhaber: EADS Deutschland GmbH, 81663 München (DE)
(72) Erfinder: Adolph, Markus, 89073 Ulm (DE); Ludwig, Michael, 89155 Erbach (DE); Brokmeier, Axel, 89233 Neu-Ulm (DE)
(74) Vertreter: Meel, Thomas

(56) Entgegenhaltungen:
- EP-A- 0 391 635
- US-A- 4 216 445
- US-A- 4 249 144
- US-A- 5 345 199

## Beschreibung

Die in der Ansprüchen definierte Erfindung geht aus von einem Amplitudenbegrenzer für ein HF-Signal nach dem Oberbegriff des Patentanspruchs 1.

Die Erfindung ist insbesondere anwendbar für HF-Signale (Hochfrequenz-Signale) im Radar-Frequenzbereich, beispielsweise phasengesteuerte Antennen, die eine Vielzahl von Sende-/Empfangsmodulen (T/R-Module) enthalten. Jeder T/R-Modul enthält im wesentlichen einen Sendepfad, einen Empfangspfad, eine HF-Sende-/Empfangsweiche, beispielsweise einen Zirkulator, sowie Schaltelemente zum Umschalten vom Sendebetrieb auf Empfangsbetrieb oder umgekehrt. Der Zirkulator ist im allgemeinen unmittelbar mit einem Sende-/Empfangsstrahlerelement verbunden. Der Sendepfad enthält einen für den verwendeten Frequenzbereich, beispielsweise das X-Band, geeigneten HF-Leistungsverstärker, dessen HF-Ausgang mit dem Zirkulator verbunden ist. Der Empfangspfad enthält einen im allgemeinen hochempfindlichen rauscharmen HF-Eingangsvertärker, dessen HF-Eingang über den Amplitudenbegrenzer, der auch Limiter genannt wird, ebenfalls mit dessen Zirkulator verbunden ist.

In einer solchen Anordnung hat der Limiter die Aufgabe, die diesem im HF-Signalfluß nachfolgenden HF-Schaltungen, insbesondere den raucharmen HF-Eingangsverstärker vor einer für diesen zu großen HF-Eingangsleistung zu schützen. Ist nun der Limiter in vorgebbarer Weise als teilreflektierende Schaltung aufgebaut, so sind damit die nachfolgenden HF-Schaltungen schützbar. Der an dem Limiter reflektierte Anteil der HF-Leistung kann aber in nachteiliger Weise über den Zirkulator in den Ausgang des HF-Leistungsverstärkers gelangen und diesen zerstören. Dieser Vorgang kann beispielsweise auftreten, wenn ein fehlangepaßter Verbraucher an den Zirkulator angeschlossen ist, beispielsweise ein Sende-Strahlerelement.

Die **EP 0 391 635 A1** beschreibt einen Amplitudenbegrenzer, wobei das eingehende HF-Signal mittels eines Spannungsteilers, z.B. in Form eines 3 dB-Hybrid-Kopplers gleichmäßig in zwei Signalzweige aufgeteilt und mittels eines Leistungskombinierers, z.B. in Form eines 3dB-Hybrid-Kopplers wieder vereinigt wird. In den beiden Zweigen sind jeweils Limiterdioden zur Einstellung einer vorgebbaren Amplitudenschwelle geschaltet.

Die **US 4,249,144** beschreibt eine Schaltung zur Dämpfung eines HF-Signals. Dabei sind zwei 4-Tor-3dB-Hybrid-Koppler zur Aufteilung und Kombination eines HF-Signals vorhanden, wobei in jedem der beiden Teilzweige mehrere Dioden zur Signalabschwächung vorhanden sind. Das vierte Tor der 3dB-Hybrid-Koppler wird dazu verwendet, den Dioden einen Strom einzuprägen, um deren Impedanz gezielt steuern zu können.

Der Erfindung liegt daher die Aufgabe zugrunde, einen gattungsgemäßen Amplituden (Limiter) anzugeben, bei welchem die maximal durchzulassende HF-Leistung (HF-Amplitude) einstellbar ist und bei dem eine Reflexion des einfallenden HF-Signals weitgehendst vermieden wird.

Diese Aufgabe wird gelöst durch die im kennzeichnenden Teil des Patentanspruchs 1 angegebenen Merkmale. Vorteilhafte Ausgestaltungen und/oder Weiterbildungen sind den weiteren Ansprüchen entnehmbar.

Ein erster Vorteil der Erfindung besteht darin, daß der Limiter in für den Frequenzbereich geeigneter Technologie herstellbar ist, beispielsweise in Mikrostriptechnologie.

Ein zweiter Vorteil besteht darin, daß der Limiter mechanisch robust und zuverlässig herstellbar ist sowie außerdem ein sehr geringes Gewicht besitzt. Dieses ist vorteilhaft bei einer Verwendung in T/R-Modulen für eine phasengesteuerte Antenne, insbesondere dann, wenn diese einige Tausend T/R-Module enthält. Insbesondere bei einer derartigen Serienfertigung ist eine sehr kostengünstige Herstellung der Limiter möglich.

Ein dritter Vorteil besteht darin, daß der Limiter eine sehr geringe Einfügungsdämpfung besitzt. Dadurch wird bei T/R-Modulen eine Abschwächung der Empfangssignale (Echosignale) vermieden, so daß eine hohe Empfindlichkeit bei gutem Störspannungsabstand erreichbar ist.

Ein vierter Vorteil besteht darin, daß durch Verwendung eines nichtreflektierenden Limiters im Empfangspfad eines T/R-Moduls die VSWR-Abhängigkeit des im Sendepfad befindlichen HF-Leistungsverstärkers wesentlich verringert wird. Es tritt also vorteilhafterweise eine Isolation des HF-Leistungsverstärkers gegenüber sich ändernden Anpassungen am Antennenport auf.

Weitere Vorteile ergeben sich aus der nachfolgenden Beschreibung.

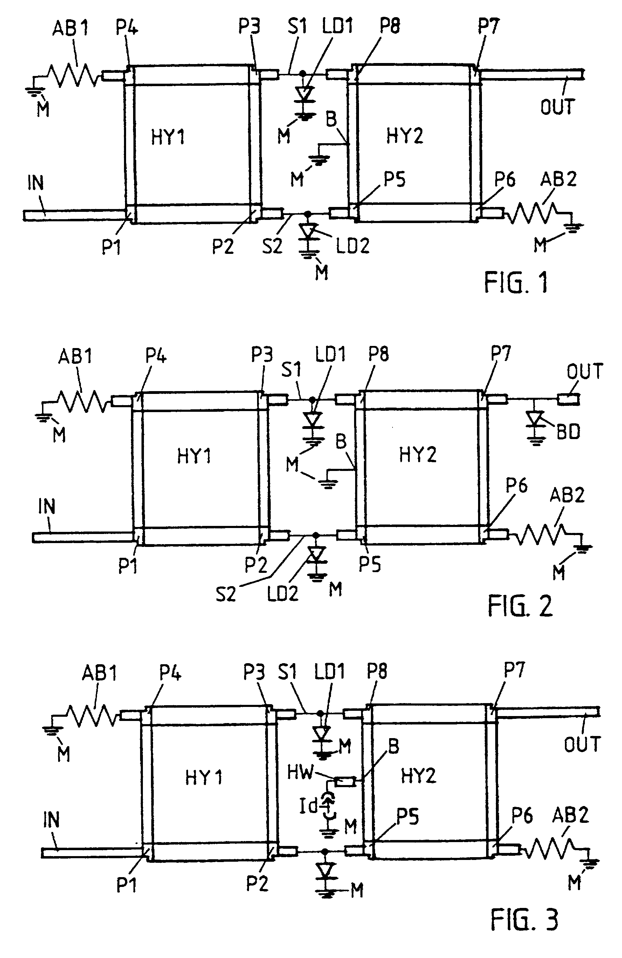

Die Erfindung wird im folgenden anhand von Ausführungsbeispielen unter Bezugnahme auf schematisch dargestellte Figuren näher erläutert. Es zeigen
- FIG. 1 bis FIG. 3: schematisch dargestellte Ausführungsbeispiele, die insbesondere für T/R-Module im X-Band geeignet sind.

FIG. 1 zeigt ein Ausführungsbeispiel eines Limiters (Amplitudenbegrenzer), bei dem eine an einen Eingang IN einfallende HF-Leistung auf das Eingangstor P1 eines ersten 3dB-Hybrids HY1 gelangt. Dort erfolgt eine Aufspaltung der HF-Leistung, jeweils zur Hälfte, auf die beiden (Serien-)Tore P2, P3, an welche jeweils ein Serienarm S1, S2 angeschlossen ist. In den Serienarmen S1, S2 ist daher jeweils ein gleiches HF-Signal (mit gleicher Amplitude) vorhanden. Zwischen diesen HF-Signalen ist jedoch eine Phasendifferenz von 90° vorhanden. Die Serienarme S1, S2 sind außerdem mit den (Serien-)Toren P5, P8 des zweiten 3dB-Hybrids HY2, der denselben Aufbau wie der erste 3dB-Hybrid HY1 besitzt, verbunden, so daß in dem zweiten 3dB-Hybrid HY2 prinzipiell eine Zusammenfassung der in den Serienarmen S1, S2 vorhandenen HF-Signale zu einem HF-Ausgangssignal erfolgt, welches an dem (Ausgangs)Tor P7 des zweiten 3dB-Hybrids HY2 anliegt und dem HF-Ausgang OUT des Limiters zugeführt wird. Die nicht benötigten Tore P4, P6 der 3dH-Hybride HY1, HY2 sind jeweils mit einem Abschlußwiderstand AB1, AB2 (HF-Sumpf) abgeschlossen, das heißt, mit einem Bezugsleiter M (Gleichspannungs-Bezugspotential, Masse) verbunden. Mit dem an dem zweiten 3dB-Hybrid HY2 dargestellten Anschluß B, der hier ebenfalls mit Masse M verbunden ist, ist prinzipiell das Gleichspannungspotential zumindest von den Serienarmen S1, S2 einstellbar. Das heißt, bei diesem Beispiel liegen die Serienarme S1, S2 ebenfalls auf dem Gleichspannungs-Bezugspotential, beispielsweise OV. Jeder der Serienarme S1, S2 ist außerdem über jeweils eine Begrenzer-Diode LD1, LD2 mit dem Bezugsleiter M verbunden. Dabei werden vorzugsweise Begrenzer-Dioden mit möglichst gleichen elektrischen Eigenschaften gewählt und gleichsinnig geschaltet, das heißt beispielsweise immer der Kathodenanschluß mit dem Bezugsleiter M verbunden.

Die nachfolgend näher erläuterte Funktionsweise des Limiters beruht darauf, daß jeder Halbleiter-Diodenübergang in Abhängigkeit von dem verwendeten Halbeitermaterial in der Dioden-Durchlaßrichtung eine Durchlaß-(Spannungs-)Schwelle besitzt. Eine Einstellung dieser Durchlaß-Schwelle bezüglich dem Bezugspotential (M) ist vorteilhafterweise möglich, beispielsweise durch eine Serienschaltung mehrerer gleichartiger Dioden und/oder durch Verwendung einer Gleichstrom-Einprägung, was anhand der FIG. 3 näher erläutert wird. Alternativ dazu ist es auch möglich, einen Transistor als Diode zu schalten und damit eine Durchlaß-Schwelle herzustellen.

Ist nun in den Serienarmen S1, S2 jeweils ein HF-Signal mit kleiner HF-Leistung vorhanden, das heißt mit einer Amplitude kleiner als die Durchlaßspannung, so werden die Begrenzer-Dioden LD1, LD2 allenfalls vernachlässigbar ausgesteuert. Es fließt also nahezu keine HF-Leistung durch die Begrenzer-Dioden LD1, LD2 zum Bezugsleiter M. In dem zweiten 3dB-Hybrid HY2 wird also die gesamte in den Serienzweigen S1, S2 geführte HF-Leistung phasengleich zusammengefaßt und über das Ausgangs-Tor P7 dem Ausgang OUT zugeführt.

Ist dagegen in den Serienarmen S1, S2 jeweils ein HF-Signal mit großer HF-Leistung vorhanden, das heißt mit einer Amplitude größer als die Durchlaßspannung der Begrenzer-Dioden LD1, LD2, so werden diese so stark ausgesteuert, daß sie im wesentlichen die gesamte HF-Leistung reflektieren. Diese gelangt über die Serienarme S1, S2 wieder in den ersten 3dB-Hybrid HY1 zurück. Durch die dort vorhandenen unterschiedlichen (elektrischen) Weglängen ergibt sich eine Auslöschung (180° Phasendifferenz) der gleich großen HF-Leistungen am Eingangs-Tor P1. An dem nicht benötigten Tor P4 überlagern sich die beiden HF-Leistungen dagegen phasengleich, laufen in den ersten Abschlußwiderstand AB1 und werden dort in (Verlust-)Wärme umgesetzt. Unabhängig von der einfallenden HF-Leistung entsteht also an dem Eingangs-Tor P1 im Idealfall vorteilhafterweise keine störende reflektierte HF-Leistung. Die beschriebene Anordnung ist also ein nichtreflektierender Begrenzer (Limiter) .

Wie bereits erwähnt, erfolgt bei hoher HF-Leistung nahezu eine vollständige Reflexion an den Begrenzer-Dioden LD1, LD2. Die dort nicht reflektierte HF-Leistung wird dem zweiten 3dB-Hybrid HY2 zugeführt und überlagert sich phasengleich bezüglich des Ausgangs-Tores P7. Dort und damit an dem Ausgang OUT könnte dadurch in nachteiliger Weise eine so große störende HF-Leistung entstehen, daß eine dem Limiter nachgeschaltete empfindliche Schaltung, beispielsweise ein erwähnter empfindlicher rauscharmer Eingangsverstärker, übersteuert oder sogar zerstört würde.

Zur Vermeidung dieses Nachteils ist bei dem Ausführungsbeispiel entsprechend FIG. 2 eine zusätzliche Begrenzer-Diode BD vorhanden. Diese ist zwischen Ausgangs-Tor P7 und dem Bezugsleiter M geschaltet. Bei einer kleinen, zulässigen HF-Leistung wird diese zusätzliche Begrenzer-Diode DB nicht ausgesteuert, so daß diese kleine HF-Leistung am Ausgang OUT anliegt. Ist dagegen am Ausgangs-Tor P7 eine unzulässig große HF-Leistung vorhanden, so wird die zusätzliche Begrenzer-Diode BD ausgesteuert und damit die HF-Leistung in die beiden 3dB-Hybride HY2, HY1 reflektiert und letztendlich vernichtet, durch Auslöschung am Eingangs-Tor P1 sowie durch Umwandlung in Wärme in den Abschlußwiderständen AB1, AB2. Auch in diesem Fall ist daher vorteilhafterweise ein nichtreflektierender Limiter vorhanden, denn an dem Eingangs-Tor P1 kann allenfalls eine vernachlässigbare reflektierte HF-Leistung austreten.

Das Ausführungsbeispiel entsprechend FIG. 3 unterscheidet sich von demjenigen der FIG. 1 lediglich dadurch, daß der Anschluß B über einen Hochfrequenzwiderstand HW (HF-Drossel) mit einer Stromquelle Id verbunden ist. Mit dieser wird ein einstellbarer eingeprägter (Gleich-)Strom erzeugt, welcher über den zweiten 3dB-Hybrid in Durchlaßrichtung durch beide Begrenzer-Dioden LD1, LD2 fließt. Dadurch wird deren Durchlaß-Schwelle in Abhängigkeit von dem eingeprägten Strom verringert. Durch diese Stromeinprägung können die Begrenzer-Dioden LD1, LD2 immer derart ausgesteuert werden, daß an diesen immer eine im wesentlichen vollständige Reflexion der in den Serienarmen S1, S2 geführten HF-Leistung erfolgt, unabhängig von deren Größe (Größe der HF-Amplitude). Wird als Stromquelle Id eine geschaltete (gepulste) Stromquelle verwendet, so ist es damit möglich, zu vorgebbaren Zeitpunkten die am Ausgang OUT anliegende HF-Leistung zwangsweise ein- oder auszuschalten.

Weiterhin ist es zusätzlich möglich, auch die weitere Begrenzer-Diode BD mittels einer Stromeinprägung zu beeinflussen sofern dieses erforderlich ist.

Die Erfindung ist nicht auf die beschriebenen Ausführungsbeispiele beschränkt, sondern sinngemäß auf weitere anwendbar. So ist beispielsweise eine Kombination der Ausführungen entsprechend FIG. 2 sowie FIG. 3 möglich.

Weiterhin ist ein solcher Limiter beispielsweise auf alle Hochfrequenzbereiche anwendbar, bei denen eine HF-Leistungsaufteilung mittels eines 3dB-Hybrids (3dB-Koppler) möglich ist.

## Patentansprüche

1. Amplitudenbegrenzer für ein HF-Signal, wobei mittels mindestens einem Halbleiterbauelement eine vorgebbare nicht überschreitbare Amplitudenschwelle einstellbar ist, wobei
- in dem Signalfluss des HF-Signals eine Serienschaltung aus zwei 3dB-Hybriden (HY1,HY2) vorhanden ist,
- die beiden 3dB-Hybride (HY1,HY2) durch zwei Serienzweige (S1,S2) verbunden sind,
- zwischen jedem Serienzweig (S1,S2) und einem Bezugsleiter (M) mit vorgebbarem Bezugspotential jeweils ein Halbleiterbauelement (LD1,LD2) zur Einstellung der vorgebbaren Amplitudenschwelle vorhanden ist, **dadurch gekennzeichnet, dass**
- die 3dB-Hybride als Vier-Tor-3dB-Hybride, die eine Phasendifferenz Δϕ= 90° zwischen den beiden Ausgangstoren erzeugen, ausgebildet sind,
- dass nicht benötigte Tore (P4,P6) der 3dB-Hybride mit jeweils einem Abschlusswiederstand (AB1,AB2) abgeschlossen sind, und die an den Halbleiterbauelementen (LD1,LD2) reflektierte Leistung dort in Verlustwärme umgesetzt wird, so dass am Eingangstor (P1) des Amplitudenbegrenzers keine reflektierte HF-Leistung vorliegt.

2. Amplitudenbegrenzer nach Anspruch 1, **dadurch gekennzeichnet, daß** die Halbleiterbauelemente (LD1, LD2) als Halbleiterdioden ausgebildet sind.

3. Amplitudenbegrenzer nach Anspruch 1 oder Anspruch 2, **dadurch gekennzeichnet, daß** zur Amplitudenbegrenzung eine weitere Begrenzer-Diode (BD), welche zwischen den Ausgang (OUT) sowie den Bezugsleiter (M) geschaltet ist, vorhanden ist.

4. Amplitudenbegrenzer nach einem der vorhergehenden Ansprüche, **dadurch gekennzeichnet, daß** an einem 3dB-Hybrid (HY2) ein Anschluß (B) vorhanden ist, über welchen den Halbleiterbauelementen (LD1, LD2) und/oder der weiteren Begrenzer-Diode (BD) ein eingeprägter Strom in Abhängigkeit von der einzustellenden Amplitudenschwelle zuführbar ist.

5. Amplitudenbegrenzer nach einem der vorhergehenden Ansprüche, **dadurch gekennzeichnet, daß** zwischen dem Anschluß (B) und einer Stromquelle (Id) zur Erzeugung des eingeprägten Stroms ein Hochfrequenz-Widerstand (HW) vorhanden ist.

6. Amplitudenbegrenzer nach einem der vorhergehenden Ansprüche zur Verwendung als nichtreflektierender Begrenzer im Empfangszweig einer Radaranlage, wobei der Begrenzer im Signalfluß einem Empfangsverstärker vorgeschaltet ist.

7. Amplitudenbegrenzer nach einem der vorhergehenden Ansprüche zur Verwendung als nichtreflektierender Begrenzer im Empfangszweig eines Sende-/Empfangsmodules für eine phasengesteuerte Radar-Antenne, wobei der Begrenzer im Signalfluß einem rauscharmen Empfangsverstärker vorgeschaltet ist.

8. Amplitudenbegrenzer nach einem der vorhergehenden Ansprüche, **dadurch gekennzeichnet, daß** zumindest die 3dB-Hybride (HY1, HY2) sowie die Halbleiterbauelemente (LD1, LD2) für das X-Band ausgebildet sind.

9. Amplitudenbegrenzer nach einem der vorhergehenden Ansprüche, **dadurch gekennzeichnet, daß** zumindest die 3dB-Hybride (HY1, HY2) in integrierter Leitungstechnologie ausgebildet sind.

## Claims

1. Amplitude limiter for an RF signal, in which an amplitude threshold which can be predetermined but not be exceeded can be set by means of at least one semiconductor component, in which
- a series circuit formed by two 3dB hybrids (HY1, HY2) is provided in the RF signal flow,
- the two 3dB hybrids (HY1, HY2) are connected by means of two series paths (S1, S2),
- a semiconductor component (LD1, LD2) for setting the amplitude threshold which can be predetermined is provided between each series path (S1, S2) and a reference conductor (M) at a reference potential which can be predetermined, **characterized in that**
- the 3dB hybrids are in the form of four-port 3dB hybrids, which produce a phase difference of Δϕ = 90° between the two output ports,
- **in that** ports (P4, P6) which are not required in the 3dB hybrids are each terminated by a terminating resistor (AB1, AB2), and the power which is reflected on the semiconductor components (LD1, LD2) is converted into heat losses there, so that no reflected RF power is present at the input port (P1) of the amplitude limiter.

2. Amplitude limiter according to Claim 1, **characterized in that** the semiconductor components (LD1, LD2) are in the form of semiconductor diodes.

3. Amplitude limiter according to Claim 1 or Claim 2, **characterized in that** a further limiter diode (BD), which is connected between the output (OUT) and the reference conductor (M), is provided for amplitude limiting.

4. Amplitude limiter according to one of the preceding claims, **characterized in that** one 3dB hybrid (HY2) has a connection (B) via which the semiconductor components (LD1, LD2) and/or the further limiter diode (BD) can be supplied with a stabilized current as a function of the amplitude threshold to be set.

5. Amplitude limiter according to one of the preceding claims, **characterized in that** a radiofrequency resistor (HW) is provided between the connection (B) and a current source (Id) for producing the stabilized current.

6. Amplitude limiter according to one of the preceding claims for use as a non-reflecting limiter in the reception path of a radar system, with the limiter being connected upstream of a receiving amplifier in the signal flow.

7. Amplitude limiter according to one of the preceding claims for use as a non-reflecting limiter in the reception path of a transmitting/receiving module for a phase-controlled radar antenna, with the limiter being connected upstream of a low-noise receiving amplifier in the signal flow.

8. Amplitude limiter according to one of the preceding claims, **characterized in that** at least the 3dB hybrids (HY1, HY2) and the semiconductor components (LD1, LD2) are designed for X band.

9. Amplitude limiter according to one of the preceding claims, **characterized in that** at least the 3dB hybrids (HY1, HY2) are designed using integrated line technology.

## Revendications

1. Limiteur d'amplitude pour un signal à haute fréquence, avec lequel un seuil d'amplitude pouvant être prédéfini et ne devant pas être dépassé peut être réglé à l'aide d'au moins un composant semiconducteur, avec lequel
- un circuit série composé de deux jonctions hybrides de 3 dB (HY1, HY2) est présent dans le trajet du signal à haute fréquence,
- les deux jonctions hybrides de 3 dB (HY1, HY2) sont reliées par deux branches série (S1, S2),
- un composant semiconducteur (LD1, LD2) destiné à régler le seuil d'amplitude pouvant être prédéfini est à chaque fois présent entre chacune des branches série (S1, S2) et un conducteur de référence (M) qui présente un potentiel de référence pouvant être prédéfini, **caractérisé en ce que**
- les jonctions hybrides de 3 dB sont réalisées sous la forme de jonctions hybrides de 3 dB à quatre portes qui produisent une différence de phase Δϕ = 90° entre les deux portes de sortie,
- que les portes non utilisées (P4, P6) des jonctions hybrides de 3 dB se terminent respectivement par une résistance de terminaison (AB1, AB2) et la puissance réfléchie au niveau des composants semiconducteurs (LD1, LD2) y est transformée en chaleur perdue de manière à ce qu'aucune puissance HF réfléchie ne soit présente à la porte d'entrée (P1) du limiteur d'amplitude.

2. Limiteur d'amplitude selon la revendication 1, **caractérisé en ce que** les composants semiconducteurs (LD1, LD2) sont réalisés sous la forme de diodes à semiconducteur.

3. Limiteur d'amplitude selon la revendication 1 ou la revendication 2, **caractérisé en ce qu'**une diode de limitation supplémentaire (BD) est présente pour la limitation de l'amplitude, laquelle est branchée entre la sortie (OUT) et le conducteur de référence (M).

4. Limiteur d'amplitude selon l'une des revendications précédentes, **caractérisé en ce qu'**au niveau d'une jonction hybride de 3 dB (HY2) est présente une borne (B) par le biais de laquelle un courant appliqué peut être acheminé aux éléments semiconducteurs (LD1, LD2) et/ou à la diode de limitation supplémentaire (BD) en fonction du seuil d'amplitude à régler.

5. Limiteur d'amplitude selon l'une des revendications précédentes, **caractérisé en ce qu'**une résistance à haute fréquence (HW) est présente entre la borne (B) et une source de courant (Id) pour produire le courant appliqué.

6. Limiteur d'amplitude selon l'une des revendications précédentes destiné à être utilisé comme limiteur non réfléchissant dans la branche de réception d'un équipement radar, avec lequel le limiteur est branché en amont dans le trajet du signal d'un amplificateur de réception.

7. Limiteur d'amplitude selon l'une des revendications précédentes destiné à être utilisé comme limiteur non réfléchissant dans la branche de réception d'un module d'émission/réception pour une antenne radar commandée en phase, avec lequel le limiteur est branché en amont dans le trajet du signal d'un amplificateur de réception à faible bruit.

8. Limiteur d'amplitude selon l'une des revendications précédentes, **caractérisé en ce qu'**au moins les jonctions hybrides de 3 dB (HY1, HY2) ainsi que les composants semiconducteurs (LD1, LD2) sont configurés pour la bande X.

9. Limiteur d'amplitude selon l'une des revendications précédentes, **caractérisé en ce qu'**au moins les jonctions hybrides de 3 dB (HY1, HY2) sont réalisées dans la technologie des circuits intégrés.
